# DEMANDE DE BREVET EUROPEEN

(11) **EP 4 815 194 A2**
(43) Date de publication de la demande: **30.09.2026**
(21) Numéro de dépôt: 26167744.7
(22) Date de dépôt: 25.03.2026
(51) Int. Cl.: H01Q 1/22, H01Q 15/08, H10W 44/20, H01P 3/12

(54) **DISPOSITIF RADIOFRÉQUENCE DE TYPE BGA**

(30) Priorité: 28.03.2025 FR 2503207
(71) Demandeur: STMicroelectronics International N.V., 1228 Plan-les-Ouates, Geneva (CH)
(72) Inventeur: VELAYUDHAN, Vipin, 38100 Grenoble (FR); PERMINJAT, Florian, 38160 Saint Romans (FR); LOPEZ, Jerome, 38430 Saint Jean de Moirans (FR); AUCHERE, David, 38240 Meylan (FR); SCHWARTZ, Laurent, 38500 La Buisse (FR)
(74) Mandataire: Cabinet Beaumont

(57) **Abrégé**

La présente description concerne un dispositif radiofréquence de type BGA comprenant une puce radiofréquence (610) montée sur une première face principale (101) d'un substrat (100) stratifié comprenant une traversée RF verticale,
une pièce métallisée (900) étant attachée sur une deuxième face principale (102) du substrat (100) en regard de la traversée RF verticale, la pièce métallisée (900) étant configurée pour être disposée en regard d'un trou traversant (710) d'un circuit imprimé et de préférence étant configurée pour être partiellement insérée dans le trou traversant (710) du circuit imprimé (700),
la pièce métallisée (900) comprenant un élément en un matériau diélectrique (910) dont les parois latérales sont partiellement, voire totalement, recouvertes par un revêtement (920) en matériau électriquement conducteur.

## Description

### Domaine technique

La présente description concerne de façon générale les substrats pour dispositif électronique émettant et/ou recevant des signaux radiofréquence. De tels dispositifs trouvent, par exemple, des applications dans le domaine des radars automobiles par exemple dans les systèmes automobiles d'aide à la conduite (ADAS pour 'Advanced Driver Assistance Systems').

### Technique antérieure

Typiquement, dans les dispositifs ADAS, des signaux radiofréquences (76 GHz-81GHz) sont émis et reçus par des antennes. Les délais d'émission et de réception sont utilisés pour calculer la distance de l'objet. Ensuite, plusieurs radars avec des algorithmes de traitement d'image sont utilisés pour identifier la forme de l'objet. Ce type de système ou de fonction est appelé RADAR.

Les dispositifs peuvent avoir plusieurs architectures. Dans les dispositifs ayant une architecture de lanceur sur boîtier (LoP pour 'Launcher on Package'), une puce est placée sur la face supérieure d'un substrat de type BGA ('Ball Grid Array'), lui-même disposé sur un circuit imprimé (PCB) muni de trous traversants (PTH ou 'Plated Through Holes'). Un module de guide antenne comprenant une antenne et un guide d'onde est placé sur l'autre côté du PCB.

Ainsi, les signaux peuvent aller de la puce au module antenne à travers le PCB.

Les dimensions des trous traversants du PCB, et donc et donc celles du PCB, dépendent de la fréquence de coupure du guide d'ondes RF.

Or, dans le cas d'une architecture de lanceur sur boîtier, il est nécessaire d'intégrer plusieurs lanceurs dans un seul boitier.

Il existe donc un besoin de réduire les dimensions des trous traversants des circuits imprimés des dispositifs RF sans modifier les fréquences de coupure.

### Résumé de l'invention

Un mode de réalisation pallie tout ou partie des inconvénients des dispositifs connus.

Un mode de réalisation prévoit un dispositif radiofréquence, par exemple de type BGA, comprenant une puce radiofréquence montée sur une première face principale d'un substrat stratifié comprenant une traversée RF verticale, une pièce métallisée étant attachée sur une deuxième face principale du substrat en regard de la traversée RF verticale, la pièce métallisée étant configurée pour être montée en regard d'un trou traversant d'un circuit imprimé, et de préférence pour être insérée dans le trou traversant du circuit imprimé,
la pièce métallisée comprenant un élément en un matériau diélectrique dont les parois latérales sont partiellement, voire totalement, recouvertes par un revêtement en matériau électriquement conducteur.

Selon un mode de réalisation, la pièce métallisée est attachée sur la deuxième face principale du substrat stratifié au moyen d'une couche de colle, notamment une colle époxy.

Selon un mode de réalisation, le matériau diélectrique a une permittivité diélectrique supérieure ou égale à 2 et, de préférence, inférieure à 10.

Selon un mode de réalisation, le matériau diélectrique est en verre.

Selon un mode de réalisation, le revêtement de la pièce métallisée est en métal ou en alliage de métaux, de préférence en argent.

Selon un mode de réalisation, une deuxième face principale (face inférieure) de la pièce métallisée est positionnée en regard du trou traversant au niveau de la première face du circuit imprimé ou dans le trou traversant entre la première face et la deuxième face du circuit imprimé, la pièce métallisée étant insérée dans le trou traversant sur une profondeur, de préférence, d'au moins 0,3 mm.

Selon un mode de réalisation, les parois latérales de la pièce métallisée ont une hauteur d'au moins 50 µm, et de préférence d'au moins 100µm, par exemple 300 µm.

Un autre mode de réalisation prévoit un système d'émission/réception d'un signal radiofréquence, comprenant un dispositif radiofréquence tel que défini précédemment, positionné sur une première face d'un circuit imprimé, un module antenne étant disposé sur une deuxième face du circuit imprimé, et étant couplé au dispositif radiofréquence grâce à un trou traversant du circuit imprimé, la pièce métallisée étant disposée en regard du trou traversant du circuit imprimé, et de préférence étant partiellement insérée dans le trou traversant du circuit imprimé.

Selon un mode de réalisation, le trou traversant est un trou oblong dont la plus grande dimension est comprise entre 1 mm et 3 mm, de préférence entre 1,1 mm et 2,54 mm et la plus petite dimension est comprise entre 0,4 mm et 1,5 mm, de préférence entre 0,55 mm et 1,1 mm.

Selon un mode de réalisation, une couche de polymère électriquement isolant est disposée entre le substrat stratifié et le circuit imprimé, autour de la pièce métallisée.

Selon un mode de réalisation, le trou traversant est rempli par un matériau électriquement isolant, par exemple une résine époxy.

Un autre mode de réalisation prévoit un procédé de fabrication d'un dispositif radiofréquence tel que défini précédemment comprenant une étape au cours de laquelle on attache, de préférence au moyen d'une couche de colle, la pièce métallisée sur le substrat stratifié.

Un autre mode de réalisation prévoit un procédé de fabrication d'un système d'émission/réception d'un signal radiofréquence tel que défini précédemment, comprenant une étape au cours de laquelle un dispositif radiofréquence tel que défini précédemment est assemblé, par exemple par brasage, sur la première face du circuit imprimé, le module antenne étant disposé sur la deuxième face du circuit imprimé, et étant couplé au boitier radiofréquence grâce au trou traversant le circuit imprimé, la pièce métallisée étant disposée en regard du trou traversant du circuit imprimé, et de préférence étant partiellement insérée dans le trou traversant du circuit imprimé.

Selon un mode de réalisation, après l'assemblage du dispositif radiofréquence avec le circuit imprimé, le procédé comprend une étape au cours de laquelle une couche de polymère électriquement isolant est injectée entre le substrat stratifié et le circuit imprimé, autour de la pièce métallisée, et de préférence, une étape ultérieure au cours de laquelle un matériau électriquement isolant, par exemple une résine époxy, est injectée dans le trou traversant.

Un autre mode de réalisation prévoit un procédé de fabrication d'une pièce métallisée comprenant les étapes suivantes :
- fournir un élément en un matériau diélectrique, de préférence en verre,
- déposer un revêtement en matériau électriquement conducteur, de préférence en métal, par exemple en argent, sur les parois latérales de l'élément en matériau diélectrique, par exemple par pulvérisation, jet d'encre ou PVD.

Selon un mode de réalisation, l'élément en matériau diélectrique est recouvert localement par un élément de protection lors du dépôt, moyennant quoi les parois latérales de l'élément sont partiellement revêtues par le matériau électriquement conducteur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, la figure 2 et la figure 3 sont des représentations schématiques, en coupe et vue de côté, d'un système d'émission/réception d'un signal radiofréquence selon différents modes de réalisation particuliers ;
la figure 4A et la figure 4B sont des représentations schématiques d'une vue en coupe et de côté de différents substrats stratifiés sur lesquels une pièce métallisée a été fixée selon deux modes de réalisation particulier ;
la figure 5A et la figure 5B sont des représentations schématiques en vue de dessus de la quatrième couche métallique des substrats stratifiés représentés respectivement sur la figure 4A et de la figure 4B ;
la figure 6 est une représentation schématique, en coupe et vue de dessus, d'un trou traversant oblong d'un circuit imprimé, selon un mode de réalisation particulier de l'invention ;
la figure 7 est un graphique représentant la longueur a d'un trou traversant oblong en fonction de la fréquence de coupure pour différents éléments (air, FR4 et verre) positionnés dans le trou oblong ;
la figure 8 représente différentes étapes successives (vues A, B, C, D et E) d'un procédé de fabrication d'une pièce diélectrique métallisée selon un mode de réalisation particulier ;
la figure 9 représente différentes étapes successives (vues A, B, C, D et E) d'un procédé de fabrication d'une pièce diélectrique métallisée selon un mode de réalisation particulier ;
la figure 10 représente différentes étapes successives (vues A, B et C) d'un procédé de fabrication d'une pièce diélectrique métallisée selon un mode de réalisation particulier.

Les figures ne sont pas nécessairement à une échelle uniforme afin de les rendre plus lisibles.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les applications des modes de réalisation décrits et les utilisations de l'antenne ne sont pas décrites.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures. En particulier, le terme propagation verticale ou traversée RF verticale fait référence à une propagation ou une traversée RF selon l'axe z.

Sauf précision contraire, les expressions "environ", "approximativement", "sensiblement", et "de l'ordre de" signifient à 10 % près, de préférence à 5 % près.

Par entre X et Y, on entend que les bornes X et Y sont incluses.

Le boitier qui va être décrit par la suite peut être utilisé pour des applications radiofréquences. Par radiofréquence (RF), on entend des fréquences comprises entre 3 kHz et 300 GHz, et plus particulièrement des fréquences comprises entre 76 GHz et 81 GHz pour la fabrication de radars automobiles de type ADAS. Même si la description mentionne en particulier les fréquences d'environ 76GHz à 81GHz, d'autres fréquences peuvent être utilisées pour d'autres dispositifs utilisant d'autres radiofréquences. Les applications peuvent également concerner des micro-ondes ou des ondes millimétriques.

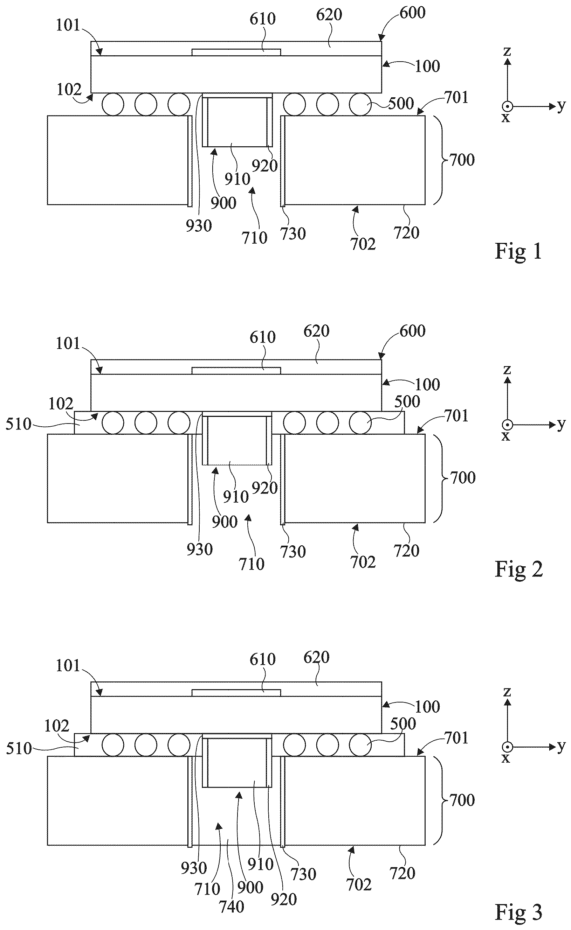

Comme représenté sur les figures 1, 2 et 3, le dispositif radiofréquence comprend un substrat stratifié 100 et un boitier 600 comprenant au moins un composant électronique 610 et, en particulier, au moins un composant radiofréquence 610, moulé dans un matériau isolant 620 (ou composé de moulage), comme un polymère ou une résine. Le dispositif RF comprend également une pièce métallisée 900 fixée sur la face inférieure 102 du substrat 100 stratifié. Lorsque le circuit imprimé 700 est assemblé au substrat stratifié 100, la pièce métallisée 900 est positionnée en regard du trou traversant 710 (ou via) du circuit imprimé 700 (PCB ou 'printed circuit board'). De préférence, la pièce métallisée 900 pénètre dans le trou traversant 710.

La pièce métallisée 900 est en verre ou en tout autre matériau diélectrique à faible perte et à permittivité diélectrique élevée (typiquement avec εr supérieur ou égal à 2 et inférieur à 10). La pièce métallisée 900 permet de réduire la taille du trou traversant 710 du PCB 700 tout en conservant les mêmes fréquences de coupure.

Nous allons maintenant décrire les différents éléments du dispositif RF en faisant référence aux figures 1, 2, 3, 4A, 4B, 5A, 5B et 6.

Sur les différentes figures, le substrat stratifié 100 est un substrat à matrice de billes (aussi appelé substrat BGA pour 'Ball Grid Array'). Cependant, il pourrait également s'agir d'un substrat à matrice de pastilles (ou LGA pour 'Land Grid Array') ou encore d'un substrat à matrice de broches (ou PGA pour 'Pin Grid Array').

Le substrat 100 comprend une première face principale 101 et une deuxième face principale 102.

La première face principale 101 peut être connectée à une puce ou plusieurs puces et la deuxième face principale 102 peut être assemblée à un circuit imprimé 700 (PCB pour 'printed circuit board'). La deuxième face 102 du substrat 100 est recouverte d'une matrice de billes 500. Les billes 500 sont des plots de connexion permettant de fixer le substrat 100 sur un dispositif externe 700, par exemple un circuit imprimé.

Le substrat 100 comprend, de préférence, au moins quatre couches métalliques 110, 120, 130, 140 depuis la première face principale 101 jusqu'à la deuxième face principale 102. La première couche métallique 110 se situe du côté de la première face 101. La quatrième couche métallique 140 se situe du côté de la deuxième face 102.

Nous décrirons plus particulièrement un substrat avec quatre couches métalliques mais il pourrait y avoir moins de quatre mais également plus de quatre couches métalliques (cinq ou six par exemple), par exemple en ajoutant des couches métalliques intermédiaires entre les couches métalliques précitées.

Les couches métalliques 110, 120, 130, 140 peuvent être en un métal ou en un alliage de métaux. Elles sont par exemple, en un matériau choisi parmi l'or, le cuivre, l'aluminium, un alliage de cuivre et d'aluminium. Les couches métalliques 110, 120, 130, 140 ont, par exemple, une épaisseur comprise entre 5 et 50 µm, de préférence entre 5 et 35 µm, et encore plus préférentiellement entre 15 et 25 µm. Les couches métalliques 110, 120, 130, 140 ont, par exemple, une épaisseur de 40 µm.

Par exemple, les couches métalliques 110, 120, 130, 140 sont des feuilles métalliques, des feuilles de cuivre notamment.

Les différentes couches métalliques 110, 120, 130, 140 sont positionnées les unes au-dessus des autres. Les couches métalliques 110, 120, 130, 140 ont séparées les unes des autres par des couches diélectrique 210, 220, 230 afin de les isoler les unes des autres. Chaque couche métallique a une épaisseur, par exemple, comprise entre 20 et 400 µm.

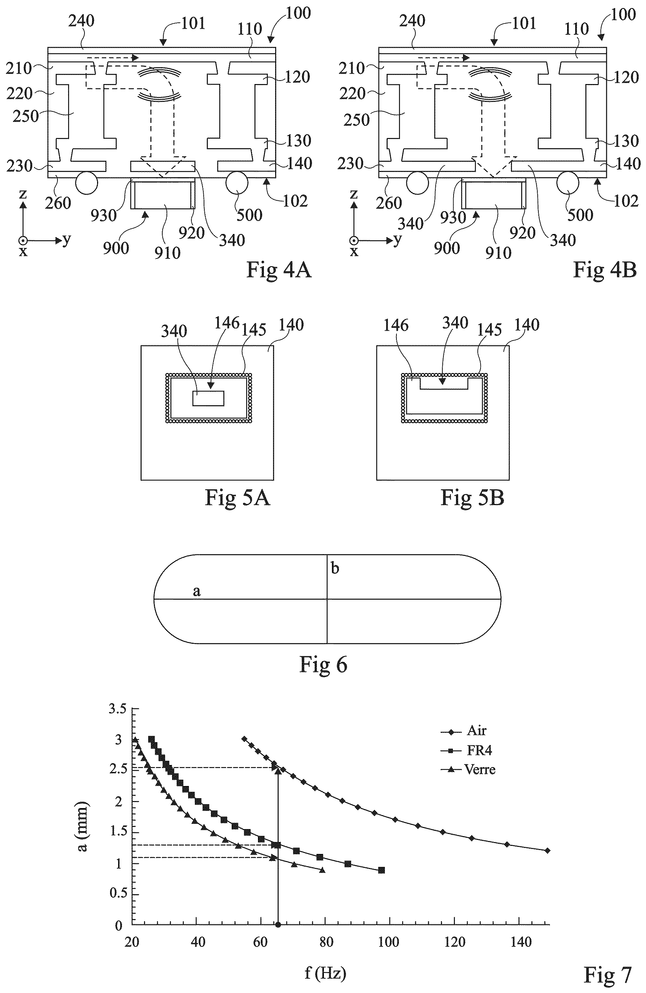

On obtient un empilement comprenant une alternance de couches métalliques 110, 120, 130, 140 et de couches diélectriques 210, 220, 230 (figures 4A et 4B). L'empilement du substrat stratifié 100 comprend successivement depuis la première face principale 101 jusqu'à la deuxième face principale 102 :
- la première couche métallique 110,
- la première diélectrique 210,
- la deuxième couche métallique 120,
- la deuxième couche diélectrique 220,
- la troisième couche métallique 130,
- la troisième couche diélectrique 230,
- la quatrième couche métallique 140.

Des couches diélectriques additionnelles 240, 260 peuvent être disposées de part et d'autre de l'empilement précédemment décrit afin d'isoler les couches métalliques 110, 140.

Les couches diélectriques 210, 220, 230, 240, 260 sont en un matériau permettant la transmission du champ électromagnétique. Elles ont, par exemple, une constante diélectrique supérieure à 2. Les couches diélectriques 210, 220, 230, 240, 260 sont, par exemple, formées d'un matériau dit pré-imprégné (ou 'prepreg'). Par matériau pré-imprégné, on entend un matériau composite comprenant un polymère thermoplasqtique ou une résine thermodurcissable et des charges, par exemple des fibres de verre. Les couches diélectriques peuvent également être en ABF ('Ajinomoto's Insulation film^{®}').

La deuxième couche diélectrique 220 forme le cœur de l'empilement ('core') et peut être en un matériau différent des autres couches diélectriques 210, 230, 240, 260. Elle est, par exemple, en une résine pouvant contenir des fibres, notamment des fibres de verre, par exemple en une résine époxy contenant des fibres de verre. Elle peut être, par exemple, en un matériau ayant une constante diélectrique supérieure à 2. Par exemple, elle est en un matériau FR-4('Flame Retardant 4'). La deuxième couche diélectrique 220 peut avoir une épaisseur comprise entre 100 et 150 µm.

Des cavités ('slot') sont formées dans les couches métalliques 110, 120, 130, 140 de chaque niveau.

Au moins les cavités des deuxième, troisième et quatrième couches 120, 130, 140 sont positionnées les unes au-dessus des autres selon l'axe z, de manière à former une traversée RF verticale (aussi appelée traversée RF ou 'feedthrough RF') et pouvoir transmettre les radiofréquences de la puce 610 au PCB 700. La traversée RF verticale traverse ainsi les différents niveaux du substrat laminé BGA 100. Cette traversée RF verticale maximise la largeur de bande sans augmenter la taille ou la perte d'insertion.

La taille de la cavité détermine la fréquence et le champ de propagation vers le guide d'ondes (TE10).

Les cavités peuvent être remplies partiellement ou totalement, par le matériau diélectrique de la couche diélectrique inférieure ou supérieure.

Dans la cavité de la première couche métallique 110, s'étend une ligne de transmission (aussi appelée ligne d'alimentation ; non représentée sur les figures). La ligne de transmission est disposée de manière coplanaire à la première couche métallique 110 (i.e. elles sont dans le même plan xOy). La ligne de transmission 400 est, par exemple, destinée à être connectée à la puce 610. La ligne de transmission 400 est en métal. Elle peut être, par exemple, en cuivre, en aluminium ou en or. La ligne de transmission 400 comprend un élément longitudinal, tel qu'un fil ou un ruban, et une extrémité. L'extrémité de la ligne de transmission peut avoir une forme carrée, rectangulaire ou triangulaire. La longueur et la largeur de la ligne de transmission dépendent de la fréquence.

La première couche métallique 110 et la ligne de transmission 400 forment un premier niveau du substrat 100 et jouent le rôle d'adaptation d'impédance. L'impédance est modifiée : il y a une transition d'une impédance inférieure dans la ligne de transmission à une impédance supérieure dans le guide d'ondes. L'orientation du signal est également modifiée de 90° entre la première cavité et la deuxième cavité 126 (représentées par des flèches sur les figures 4A, 4B), permettant ensuite une propagation verticale du signal à travers les cavités suivantes.

De préférence, au moins une cavité choisie parmi la deuxième cavité, la troisième cavité et la quatrième cavité comprend un élément d'adaptation de la fréquence 340. De préférence, au moins la quatrième cavité 146 comprend un élément d'adaptation 340 (comme par exemple représenté sur les figures 4A, 4B, 5A et 5B). Les éléments d'adaptation de la fréquence 340 sont configurés pour canaliser le signal électromagnétique dans les cavités.

Sur les figures, un seul élément d'adaptation 340 est représenté, cependant il est possible d'avoir un élément d'adaptation positionné dans plusieurs cavités d'un même substrat 100.

Les éléments d'adaptation de la fréquence peuvent avoir des dimensions différentes. En fonction des caractéristiques recherchées, les éléments d'adaptation de la fréquence peuvent être positionnés au centre de la cavité ou sur les bords de la cavité et/ou avoir des formes différentes. Les éléments d'adaptation ne sont pas forcément alignés les uns avec les autres.

Selon un mode de réalisation, l'élément d'adaptation de la fréquence 340 peut être une plaque ('patch') isolée des bords de la cavité 146 par un espace (figures 4A, 5A). La plaque 340 est, par exemple, une plaque métallique. Par exemple, il s'agit d'une plaque en cuivre. La plaque peut être en un même matériau que la couche métallique. Les plaques sont de préférence en un matériau conducteur, de préférence en un métal, par exemple en cuivre, en aluminium, en un alliage de cuivre et d'aluminium ou en or. Les plaques sont, par exemple, rectangulaires ou carrées. Elles pourraient également être circulaires. Les plaques peuvent avoir la même épaisseur que les couches métalliques ou une épaisseur identique à 10% voire 5% près.

Selon un autre mode de réalisation, l'élément d'adaptation d'impédance 340 peut être une partie de la couche métallique qui fait saillie dans la cavité (figure 4B, 5B). Autrement dit, une partie de la couche métallique se prolonge dans la cavité et forme une avancée ou proéminence dans la cavité 146. La partie faisant saillie forme une extension interne de la plaque métallique au niveau d'un bord de la cavité ou d'un coin de la cavité. Les parties faisant saillie sont, par exemple, rectangulaires ou carrées. Les parties faisant saillie ont la même épaisseur que les couches métalliques. Les formes irrégulières des parties faisant saillie et/ou de la cavité permettent de faire correspondre la fréquence et la largeur de bande.

Ces modes de réalisation peuvent être combinés. Il est possible au sein d'un même dispositif d'utiliser des plaques pour un ou plusieurs niveaux et des parties faisant saillie pour un ou plusieurs niveaux.

L'empilement comprend également des vias métalliques intercouches 250 formés à travers une partie des couches de l'empilement ou à travers toutes les couches de l'empilement de manière à pouvoir connecter différentes couches métalliques 110, 120, 130, 140 les unes avec les autres. Les vias métalliques intercouches 250 peuvent être superposés les uns sur les autres ('stacked') ou décalés les uns par rapport aux autres.

Chaque cavité peut être entourée par une rangée de vias pour aider à confiner les ondes électromagnétiques à l'intérieur des cavités et/ou empêcher les fuites de signal. Les différentes rangées de vias sont positionnées les unes au-dessus des autres selon l'axe z. Il est possible d'avoir une rangée de vias ou plusieurs rangées de vias par couche métallique 110, 120, 130, 140. Par exemple, sur les figures 5A et 5B seule une rangée de via 145 est représentée autour de la quatrième cavité 146. Ces cavités ont également une certaine impédance et une certaine fréquence de fonctionnement.

Un tel substrat conduit à l'obtention d'une large traversée RF à large bande et faible perte aux fréquences désirées. Cet empilement permet de s'adapter à toute la bande de radiofréquences recherchées (en particulier 76 GHz - 81 GHz).

De plus, avec un tel substrat 100, il est possible d'obtenir une bande passante un peu plus large que la gamme de fréquence classiquement utilisée dans les radars automobiles (76GHz - 81GHz), ce qui permet d'être moins sensible à la fabrication. Il est possible de dimensionner les cavités et les éléments d'adaptation en fonction de la fréquence de travail et/ou du substrat. Des fréquences comprises entre 24,0 et 24,25 GHz peuvent également être utilisées.

Cette traversée compacte et performante peut être réalisée à l'aide d'une technologie de substrat stratifié 100 standard. Les coûts sont ainsi réduits.

La traversée RF est configurée pour être montée en regard d'un trou traversant 710 d'un circuit imprimé 700.

L'épaisseur du substrat 100 est, par exemple, comprise entre 100 et 900 µm, par exemple entre 100 et 200 µm, par exemple de l'ordre de 150 µm, ou entre 200 et 300 µm.

En plus du substrat 100 décrit précédemment, le dispositif radiofréquence comprend également un boitier RF 600. Le boitier RF 600 comprend un composant radiofréquence 610 et un composé de moulage 620. Le composant RF 610 est un composant apte à transmettre et recevoir des signaux radiofréquences spécifiques. En particulier le composant radiofréquence 610 est une puce radiofréquence 610.

La puce 610 présente en face avant des plages de connexion recouverts par des plots métallisés ('bumps' ; non représentés). Les plots métallisés sont par exemple en étain ou en un alliage à base d'étain.

La puce 610 est montée directement sur le substrat stratifié 100, les plots ('bumps') de la puce 610 sont orientés du côté de la première face 101 du substrat 100 ('flip-chip'). La puce 610 est connectée au substrat 100 par ses plots. Elle pourrait être fixée au substrat par brasage de fil ('wire bonding').

La puce 610 est connectée à la ligne de transmission du substrat 100, par exemple au moyen de microrubans.

Le dispositif comprend, en plus, une pièce métallisée 900.

La pièce métallisée 900 comprend une pièce (ou élément) 910 en un matériau diélectrique et un revêtement 920 électriquement conducteur.

L'élément 910 est, de préférence, un monobloc.

L'élément 910 peut avoir différentes formes : il peut s'agir, par exemple, d'une forme oblongue, cylindrique, parallélépipédique ou cubique. De préférence, la forme est oblongue comme la forme des trous 710 traversant métallisés du circuit imprimé 700.

Le matériau diélectrique a, par exemple, une permittivité diélectrique supérieure ou égale à 2 et, de préférence, inférieure à 10, encore plus préférentiellement inférieure à 8 voire inférieure à 7. Le matériau diélectrique est, par exemple, choisi parmi : du verre, une résine époxy, un polyimide, un polytétrafluoroéthylène, un poly(oxyde de p-phénylène) (PPO), une résine de Résine de bismaléimide-triazine (BT pour Bismaléimide-Triazine), du FR-4 ou encore un composite formé d'un ou plusieurs des matériaux précités (par exemple un composite formé d'une résine époxy et de fibres de verre).

La pièce métallisée 900 comprend une première face principale (ou face supérieure) destinée à être en contact avec le substrat stratifié 100, une deuxième face principale (ou face inférieure) destinée à être positionnée en regard du via 710 traversant du circuit imprimé 700 et, de préférence, dans le via 710 traversant du circuit imprimé 700, et des faces latérales. Les faces principales sont parallèles ou sensiblement parallèles entre elles.

Les faces principales ont des dimensions choisies de manière à permettre l'insertion de la pièce métallisée 900 dans le trou traversant 710 du circuit imprimé 700.

Les faces latérales ont une hauteur choisie de manière à ce que la deuxième face principale (face inférieure) de la pièce métallisée 900 soit positionnée en regard du trou traversant 710 au niveau de la première face 701 du circuit imprimé 700 ou dans le trou traversant 710 entre la première face 701 et la deuxième face 702 du circuit imprimé 700. Les faces latérales ont, par exemple, une hauteur d'au moins 50 µm, de préférence d'au moins 100µm, par exemple 300µm. La hauteur des faces latérales se mesure selon l'axe z sur les figures 1 à 3 et 4A et 4B.

Les dimensions de la pièce 900 sont choisies de manière à recouvrir l'élément d'adaptation 340 d'impédance (autrement dit, la surface des faces principales de la pièce métallisée 900 est supérieure ou égale à celle de l'élément d'adaptation 340).

Les faces latérales sont recouvertes partiellement ou totalement par un revêtement 920. Lorsque le revêtement 920 recouvre partiellement les faces latérales, celui-ci les recouvre depuis la face supérieure. Par exemple, il recouvre au moins 40%, de préférence au moins 60% et encore plus préférentiellement entre 60% et 80% de la hauteur des faces latérales.

De préférence, les parois latérales sont entièrement recouvertes par le revêtement 920.

Le revêtement 920 est en un matériau conducteur électrique. Il est, par exemple, en métal ou en un alliage métallique. De préférence, il est en argent ou en cuivre. Il a une épaisseur, par exemple, comprise entre 100 nm et 10 µm, par exemple 2µm.

La résistivité du revêtement 920 est par exemple de 3µohm.cm.

La pièce diélectrique métallisée 900 est attachée sur le substrat stratifié 100, et plus particulièrement sur la deuxième face 102 du substrat stratifié 100.

La pièce diélectrique métallisée 900 est, de préférence, attachée sur le substrat stratifié 100 par une couche de collage 930. La colle peut être une colle époxy.

Les dispositifs RF peuvent être adaptés à différentes technologies de substrat, qui incluent des guides d'ondes RF et mmW, des connecteurs ou tout autre composant.

Un tel dispositif RF peut être utilisé dans un système d'émission/réception d'un signal RF.

Le système d'émission/réception d'un signal RF, comprend, par exemple, le dispositif radiofréquence précédemment décrit, un circuit imprimé 700, et un module antenne ou un autre guide d'onde.

Le circuit imprimé 700 comprend des trous 710 traversant métallisés (PTH ou 'Plated Through Holes') allant de la première face 701 à la deuxième face 702 du circuit imprimé 700. Les parois latérales 730 des trous traversants 710 confinent les ondes électromagnétiques. Les surfaces supérieure et inférieure du substrat 700 peuvent également être métallisées pour former le guide d'ondes. Les trous 710 sont, par exemple, des trous oblongs (figure 6). La plus grande dimension 'a' du trou oblong est, par exemple, comprise entre 1 et 3 mm, et de préférence entre 1,1 et 2,54 mm. Elle est, par exemple, de 2,54 mm ou 1,2 mm. La plus petite dimension 'b' du trou oblong est, par exemple, comprise entre 0,4 et 1,5 mm, de préférence entre 0,45 et 1,1 mm, et encore plus préférentiellement entre 0,55 et 1,1 mm. Elle est, par exemple, de 1,1 mm ou 0,55 mm. De préférence, elle est inférieure ou égale à 0,55 mm, par exemple 0,45 mm. Les dimensions 'a' et 'b' se mesurent selon les axes x ou y.

La longueur de la pièce métallisée correspond à la dimension dans le sens de la plus grande dimension 'a' du trou. La largeur de la pièce métallisée correspond à la dimension dans le sens de la plus petite dimension 'b' du trou. La longueur et la largeur de la pièce métallisée correspondent, par exemple, à entre 60% et 80% de la plus grande dimension et de la plus petite dimension du trou, respectivement.

La pièce métallisée 900 a, par exemple, une longueur comprise entre 0,6 et 2,4 mm, de préférence entre 0,66 et 2,03 mm. La pièce métallisée 900 a, par exemple, une largeur comprise entre 0,24 et 1,2 mm, de préférence entre 0,33 et 0,99 mm.

Le substrat stratifié 100 est fixé sur la première face 701 circuit imprimé 700. En particulier, les billes 500 du substrat BGA 100 sont brasées sur le circuit imprimé 700. Les billes 500 du BGA sont, par exemple, en étain ou en un alliage d'étain, tel que le SAC (alliage d'étain, argent et cuivre). Une partie des billes 500 du BGA joue le rôle de court guide d'ondes pour transmettre le signal vers le PCB 700.

Une fois l'assemblage réalisé, la pièce diélectrique métallisée 900 est en regard du trou traversant 710 du circuit imprimé 700. La deuxième face principale de la pièce diélectrique métallisée 900 peut être au même niveau que la face supérieure 701 du circuit imprimé 700. De préférence, la pièce diélectrique métallisée 900 est insérée dans le trou traversant 710, de telle manière que la deuxième face principale de la pièce métallisée 900 soit positionnée au niveau du trou traversant 710, entre la première face 701 et la deuxième face du circuit imprimé 700. La profondeur de pénétration dépend des dimensions du trou. Par exemple, elle pénètre dans le trou traversant 710 sur une profondeur d'au moins 0,3 mm. Pour un trou ayant une profondeur de 1,5 mm, elle pénètre sur une profondeur, de préférence, comprise entre 0,3 et 1,5 mm, et encore plus préférentiellement entre 0,3 et 1,25 mm. La profondeur se mesure selon l'axe z.

Par exemple, la surface des faces principales de la pièce diélectrique métallisée 900 correspond à au moins 60% et de préférence au moins 80% de la surface du trou traversant 710. La distance entre la pièce diélectrique métallisée 900 et les parois du trou traversant 710 est choisie de manière à ne pas créer de contact physique et électrique entre le revêtement 920 de la pièce métallisée 900 et les parois latérales 730 du trou traversant 710. La distance entre la pièce diélectrique métallisée 900 et les parois du trou traversant 710 est, par exemple, comprise entre 50 et 300 µm, de préférence entre 100 et 200 µm.

Une couche de polymère 510 électriquement isolant ('underfill') peut être positionnée entre le substrat stratifié 100 et le circuit imprimé 700 (figure 2). Elle améliore l'isolation électrique des plots de connexion 500 du substrat stratifié 100. Elle peut être formée par injection.

La couche de polymère 510 électriquement isolant est en contact avec la pièce diélectrique métallisée 900, et plus particulièrement avec une partie (la partie supérieure) des faces latérales de ladite pièce 900.

Selon une variante de réalisation, en plus de la couche de polymère 510, un matériau de remplissage électriquement isolant 740, par exemple une résine époxy, peut être positionné dans le trou traversant 710 (figure 3). Il est en contact avec au moins la deuxième face de la pièce diélectrique métallisée 900 et, de préférence, avec une partie des faces latérales de la pièce diélectrique métallisée 900. De préférence, la pièce diélectrique métallisée 900 et le matériau de remplissage électriquement isolant 740 remplissent le trou traversant 710. Il peut être formé par injection.

Plusieurs dispositifs RF peuvent être positionnés sur le même circuit imprimé 700, et plus particulièrement sur la première face 701 du circuit imprimé 700.

Le module antenne (non représenté) est disposé sur une deuxième face 702 du circuit imprimé 700. Le module antenne comprend un substrat dans lequel est formé un guide d'ondes et des antennes.

Le module antenne est couplé au dispositif radiofréquence grâce aux trous 710 traversants le circuit imprimé 720. Le signal est transmis de manière continue de la puce 610 au PCB 700 puis au guide d'onde et à l'antenne du module antenne.

Le signal radiofréquence est ainsi acheminé, depuis le composant radiofréquence 610, à travers le substrat BGA 100, grâce à la traversée RF verticale, puis à travers la pièce métallisée 900 jusqu'aux trous 710 formés dans le circuit imprimé 700 puis jusqu'au module antenne. Tout autre module RF pourrait également être attaché au guide d'onde.

Nous allons maintenant décrire le procédé de fabrication d'une pièce diélectrique métallisée 900, et notamment une pièce en verre métallisée.

Le procédé de fabrication d'une pièce métallisée 900 comprend les étapes suivantes :
- fournir un substrat en verre, et le positionner sur un cadre de découpe ('dicing frame'),
- découper le substrat en verre en plusieurs pièces 910 ('dicing'),
- de préférence, rincer les pièces 900, par exemple à l'eau,
- de préférence, réaliser une activation de surface des pièces 900, par exemple avec un plasma,
- métalliser les parois latérales des pièces 900, pour former un revêtement 920,
- de préférence, réaliser un post-traitement (traitement thermique et/ou traitement photonique).

De manière non exhaustive, l'étape de découpe du substrat en verre peut être réalisée par découpe mécanique (par exemple au moyen d'un outil en carbure), par découpe par jet d'eau ('waterjet cutting'), par découpe à la scie, par découpe laser, par introduction de dislocation par laser (étape dite de 'stealth dicing') puis une étape d'expansion du support de découpe, par gravure profonde induite par laser (ou LIDE pour 'Laser Induced Deep Etching'), par nanoperforation (les modifications de la surface sont réalisées par laser) et fracture.

Avec de telles méthodes, plusieurs formes de pièces 900 peuvent être obtenues.

L'étape de métallisation peut être réalisée, par exemple, par dépôt physique en phase vapeur (PVD pour 'Physical Vapor Deposition'), par pulvérisation ou par dépôt par jet d'encre.

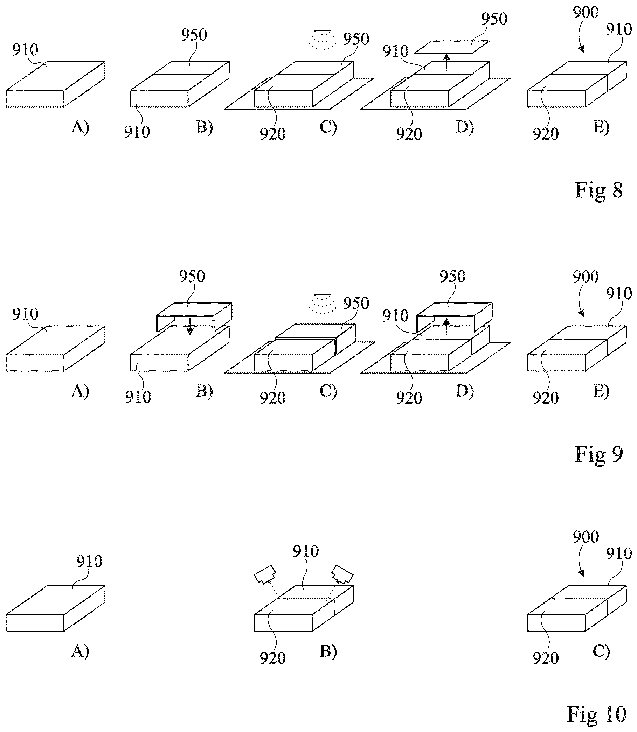

Pour les dépôts par PVD ou par pulvérisation, un élément de protection 950 peut recouvrir localement la pièce 910 (figures 8 et 9). L'élément de protection 950 peut être un revêtement ('liner') ou un masque mécanique ('mechanical part'). Pour cela, l'élément de protection 950 est posé sur la pièce 910 de manière à la recouvrir partiellement (vue B des figures 8 et 9). Le dépôt peut être réalisé pleine plaque à la fois sur l'élément de protection 950 et sur la partie de la pièce 910 non couverte par l'élément de protection 950 (vue C des figures 8 et 9). Une fois le dépôt réalisé, l'élément de protection 950 est retiré (vue D des figures 8 et 9). On obtient ainsi des pièces 900 dont les parois latérales sont partiellement métallisées (vue E des figures 8 et 9).

Pour le dépôt par jet d'encre, le dépôt peut être réalisé de manière localisée (vue B de la figure 10). Il n'est pas nécessaire d'avoir un masque recouvrant la pièce 910 lors de la métallisation.

L'épaisseur du revêtement 920 peut aller de quelques nanomètres à plusieurs dizaines de micromètres.

Le revêtement 920 peut être, par exemple, en un des métaux ou alliages suivants : Ni, Ag, Au, Ti, Ta, TiW, Al, AlCu, AgNi, Pt, etc.

### Exemples illustratifs et non limitatifs

A titre illustratif, la figure 7 représente les dimensions d'un trou oblong (dimensions 'a') en fonction de la fréquence de coupure pour de l'air et pour différentes pièces en matériaux diélectriques. Les dimensions 'b' sont fixes, soit 1,1 mm ou 0,55 mm.

Pour une fréquence de 60 Hz, la dimension 'a' est d'environ 2,5 mm pour de l'air, de 1,5 mm pour du FR4 et de 1,0 mm pour du verre.

Les dimensions du guide d'onde peuvent être réduites quand la permittivité diélectrique du matériau disposé dans le trou traversant augmente. Par exemple, avec une pièce en verre, la dimension 'a' du trou oblong peut être réduite de 50% par rapport à un milieu formé d'air.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

## Revendications

1. Dispositif radiofréquence, par exemple de type BGA, comprenant une puce radiofréquence (610) montée sur une première face principale (101) d'un substrat (100) stratifié comprenant une traversée RF verticale,
une pièce métallisée (900) étant attachée sur une deuxième face principale (102) du substrat (100) en regard de la traversée RF verticale, la pièce métallisée (900) étant configurée pour être montée en regard d'un trou traversant métallisé (710) d'un circuit imprimé (700), et de préférence pour être insérée dans le trou traversant métallisé (710) du circuit imprimé (700),
la pièce métallisée (900) comprenant un élément (910) en un matériau diélectrique dont les parois latérales sont partiellement, voire totalement, recouvertes par un revêtement (920) en matériau électriquement conducteur.

2. Dispositif selon la revendication 1, dans lequel la pièce métallisée (900) est attachée sur la deuxième face principale (102) du substrat (100) stratifié au moyen d'une couche de colle (930), notamment une colle époxy.

3. Dispositif selon l'une des revendications 1 et 2, dans lequel le matériau diélectrique a une permittivité diélectrique supérieure ou égale à 2 et, de préférence, inférieure à 10.

4. Dispositif selon l'une des revendications précédentes, dans lequel le matériau diélectrique est en verre.

5. Dispositif selon l'une des revendications précédentes, dans lequel le revêtement (920) de la pièce métallisée (900) est en métal ou en alliage de métaux, de préférence en argent.

6. Dispositif selon l'une des revendications précédentes, dans lequel une face inférieure de la pièce métallisée (900) est positionnée entre la première face (701) et la deuxième face (702) du circuit imprimé (700), la pièce métallisée (900) étant insérée dans le trou traversant métallisé (710), de préférence, sur une profondeur d'au moins 0,3 mm.

7. Système d'émission/réception d'un signal radiofréquence, comprenant un dispositif radiofréquence tel que défini dans l'une des revendications 1 à 6, positionné sur une première face (701) d'un circuit imprimé (700), un module antenne étant disposé sur une deuxième face (702) du circuit imprimé (700), et étant couplé au dispositif radiofréquence grâce à un trou traversant métallisé (710) du circuit imprimé (700),
la pièce métallisée (900) étant disposée en regard du trou traversant métallisé (710) du circuit imprimé (700), et de préférence étant partiellement insérée dans le trou traversant métallisé (710) du circuit imprimé (700).

8. Système selon la revendication précédente, dans lequel le trou traversant métallisé (710) est un trou oblong dont la plus grande dimension est comprise entre 1 mm et 3 mm, de préférence entre 1,1 mm et 2,54 mm et la plus petite dimension est comprise entre 0,4 mm et 1,5 mm, de préférence entre 0,55 et 1,1 mm.

9. Système selon l'une des revendications 7 et 8, dans lequel une couche de polymère électriquement isolant (510) est disposée entre le substrat stratifié (100) et le circuit imprimé (700), autour de la pièce métallisée (900).

10. Système selon l'une des revendications 7 à 9, dans lequel le trou traversant métallisé (710) est rempli par un matériau électriquement isolant (740), par exemple une résine époxy.

11. Système-selon l'une des revendications 7 à 10, dans lequel la pièce métallisée (900) n'est pas en contact avec les parois latérales (730) du trou traversant métallisé (710).

12. Procédé de fabrication d'un dispositif radiofréquence tel que défini dans l'une des revendications 1 à 6 comprenant une étape au cours de laquelle on attache, de préférence au moyen d'une couche de colle (930), la pièce métallisée (900) sur le substrat (100) stratifié.

13. Procédé de fabrication d'un système d'émission/réception d'un signal radiofréquence tel que défini dans l'une des revendications 7 à 10, comprenant une étape au cours de laquelle un dispositif radiofréquence tel que défini dans l'une des revendications 1 à 6 est assemblé, par exemple par brasage, sur la première face (701) du circuit imprimé (700), le module antenne étant disposé sur la deuxième face (702) du circuit imprimé (700), et étant couplé au boitier radiofréquence grâce au trou traversant métallisé (710) traversant le circuit imprimé (700), la pièce métallisée (900) étant disposée en regard du trou traversant métallisé (710) du circuit imprimé (700), et de préférence étant partiellement insérée dans le trou traversant métallisé (710) du circuit imprimé (700).

14. Procédé selon la revendication précédente, dans lequel, après l'assemblage du dispositif radiofréquence avec le circuit imprimé (700), le procédé comprend une étape au cours de laquelle une couche de polymère électriquement isolant (510) est injectée entre le substrat stratifié (100) et le circuit imprimé (700), autour de la pièce métallisée (900), et de préférence, une étape ultérieure au cours de laquelle un matériau électriquement isolant (740), par exemple une résine époxy, est injectée dans le trou traversant métallisé (710).

15. Procédé de fabrication d'une pièce métallisée (900) comprenant les étapes suivantes :
- fournir un élément en un matériau diélectrique (910), de préférence en verre,
- déposer un revêtement (920) en matériau électriquement conducteur, de préférence en métal, par exemple en argent, sur les parois latérales de l'élément en matériau diélectrique (910), par exemple par pulvérisation, jet d'encre ou PVD.

16. Procédé selon la revendication précédente, dans lequel l'élément en matériau diélectrique (910) est recouvert localement par un élément de protection (950) lors du dépôt, moyennant quoi les parois latérales de l'élément (910) sont partiellement revêtues par le matériau électriquement conducteur.
